# EUROPEAN PATENT APPLICATION

(11) **EP 1 686 424 A2**
(43) Date of publication of application: **02.08.2006**
(21) Application number: 06100780.3
(22) Date of filing: 24.01.2006
(51) Int. Cl.: G03F 7/039

(54) **Radiation-sensitive resin composition**

(30) Priority: 27.01.2005 JP 2005019105
(71) Applicant: JSR Corporation, Tokyo 104-8410 (JP)
(72) Inventor: Shimizu, Daisuke, 104-8410 Tokyo (JP); Nagai, Tomoki, 104-8410 Tokyo (JP); Yoshida, Kouichirou, 104-8410 Tokyo (JP); Mizuno, Hirotaka, 104-8410 Tokyo (JP)
(74) Representative: TBK-Patent

(57) **Abstract**

A radiation-sensitive resin composition is provided which exhibits improved resolution, sensitivity, and focal depth allowance (process margin) and can eliminate development residues when forming a resist pattern. The radiation-sensitive resin composition comprises an acid-labile group-containing resin (A) which is insoluble or scarcely soluble in alkali, but becomes alkali soluble by the action of an acid, and a photoacid generator (B), the acid-labile group-containing resin (A) comprises a copolymer prepared by anionic polymerization of monomers including a substituted or unsubstituted styrene and have a terminal shown by the following formula (x). 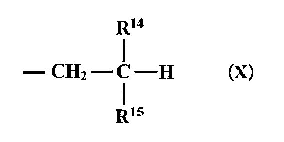 wherein R¹⁴ and R¹⁵ individually represent a hydrogen atom or a linear or branched saturated hydrocarbon group having 1-6 carbon atoms.

## Description

### BACKGROUND OF THE INVENTION

The present invention relates to a radiation-sensitive resin composition using a copolymer having a specific terminal group as an acid-labile group-containing resin, used as a chemically-amplified resist suitable for microfabrication utilizing various types of radiation, particularly, (extreme) far ultraviolet rays such as a KrF excimer laser, ArF excimer laser, F₂ excimer laser, or EUV, X-rays such as synchrotron radiation, and charged particle rays such as electron beams, and the like.

In the field of microfabrication represented by fabrication of integrated circuit devices, photolithographic technology enabling microfabrication with a line width of about 200 nm or less has been demanded in recent years in order to achieve a higher degree of integration.

Use of radiation with a short wavelength enabling microfabrication with a line width level of about 200 nm or less has been studied. As the radiation having such a short wavelength, deep ultraviolet rays such as a bright line spectrum of a mercury lamp and an excimer laser, X-rays, an electron beams, and the like can be given, for example. Of these, a KrF excimer laser (wavelength: 248 nm), an ArF excimer laser (wavelength: 193 nm), an F₂ excimer laser (wavelength: 157 nm), EUV (wavelength: 13 nm, etc., extreme ultraviolet radiation), electron beams, and the like are gaining attention.

As a radiation-sensitive resin composition applicable to short wavelength radiation, a number of compositions utilizing a chemical amplification effect brought about by a component having an acid-labile functional group and a photoacid generator which generates an acid upon irradiation (hereinafter called "exposure") have been proposed.

As the chemically-amplified radiation-sensitive composition, JP-B-02-27660 discloses a composition comprising a resin containing a t-butyl ester group of carboxylic acid or a t-butylcarbonate group of phenol and a photoacid generator. This composition utilizes the effect of the resin to release a t-butyl ester group or t-butyl carbonate group by the action of an acid generated upon exposure to form an acidic group such as a carboxyl group or a phenolic hydroxyl group, which renders an exposed area on a resist film readily soluble in an alkaline developer.

A copolymer containing a hydroxystyrene recurring unit and a recurring unit in which the hydrogen atom in the hydroxyl group of hydroxystyrene is replaced with a tertiary alkyl group is known to be used in a resist pattern forming method capable of producing a minute resist pattern without fail while ensuring high resolution, even if a long time is allocated to PED (JP-A-10-319596).

Further, as a resist material excelling in light transmittance in the neighborhood of 248.4 nm, storage stability, and the like, a copolymer having a recurring unit of a hydroxystyrene derivative with an acetal or ketal group, a hydroxystyrene recurring unit, and a recurring unit of a styrene derivative is known (JP-A-8-123032).

Characteristics demanded for a photo resist are becoming severer along with a rapid miniaturization trend of photolithography process. Not only increase in resolution, sensitivity, and focal depth allowance (process margin) that has been conventionally targeted, but also techniques for avoiding development residues in resist pattern formation and obtaining pattern profiles with minimal white edges are demanded.

However, avoiding development residues during formation of a resist pattern is difficult if a conventional copolymer containing a hydroxystyrene recurring unit is used.

### SUMMARY OF THE INVENTION

An object of the present invention is to provide a radiation-sensitive resin composition which, when used as a chemically amplified resist sensitive to far ultraviolet rays represented by a KrF excimer laser, ArF excimer laser, or F₂ excimer laser, exhibits improved resolution, sensitivity, and focal depth allowance (process margin), and can eliminate development residues in the course of resist pattern formation, thereby producing pattern profiles with minimal white edges.

The radiation-sensitive resin composition of the present invention comprises an acid-labile group-containing resin (A) which is insoluble or scarcely soluble in alkali, but becomes alkali soluble by the action of an acid on the resin, and a photoacid generator (B), wherein the acid-labile group-containing resin (A) comprises a copolymer prepared by anionic polymerization of monomers including a substituted or unsubstituted styrene and have a terminal shown by the following formula (x), 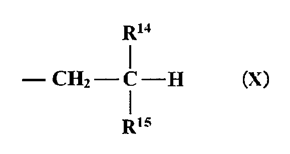 wherein R¹⁴ and R¹⁵ individually represent a hydrogen atom or a linear or branched saturated hydrocarbon group having 1-6 carbon atoms.

The above acid-labile group-containing resin (A) is preferably a copolymer containing a recurring unit (A1) having a phenolic hydroxyl group on the side chain and a recurring unit (A2) having an acid-labile group, wherein the recurring unit (A1) is prepared by copolymerizing monomers of the following formula (1) and hydrolyzing the resulting copolymer with an acid, 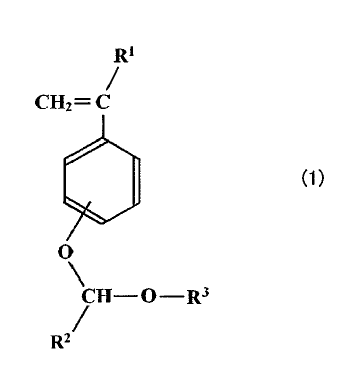 wherein R¹ represents a hydrogen atom or a methyl group, and R² and R³ represent saturated hydrocarbon groups having 1-4 carbon atoms or bond together to form a cyclic ether having 3-7 carbon atoms.

The recurring unit (A2) having an acid-labile group is preferably prepared by copolymerizing monomers of the following formula (2), 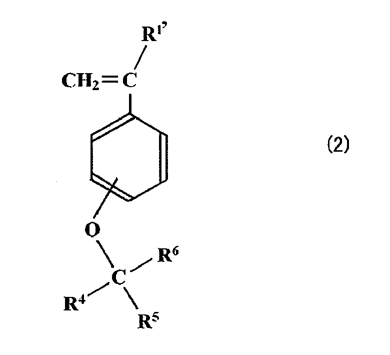 wherein R^{1'} represents a hydrogen atom or a methyl group, and R⁴, R⁵, and R⁶ represent saturated hydrocarbon groups having 1-4 carbon atoms.

The photoacid generator (B) is preferably at least one compound selected from a sulfonimide compound, an onium salt compound, and a diazomethane compound.

The copolymer of the present invention is prepared by copolymerizing a monomer, in which the recurring unit having a phenolic hydroxyl group on the side chain (A1) is shown by the formula (1), followed by hydrolysis. The terminal of the copolymer has the structure shown by the formula (x).

The hydrolysis reaction of the monomer of the formula (1) easily proceeds even in weakly acidic conditions due to low activation energy as compared with the hydrolysis reaction of butoxystyrene and the like using a strong acid such as hydrochloric acid and sulfuric acid. As a result, the recurring unit (A1) having a phenolic hydroxyl group on the side chain prepared by the hydrolysis reaction can be easily formed in the copolymer. In addition, since the monomer of the formula (1) does not react with an alkali, a stable radiation-sensitive resin composition can be prepared.

Consequently, the radiation-sensitive resin composition of the present invention exhibits increased resolution, sensitivity, and focal depth allowance (process margin), while eliminating development residues during resist pattern formation, thereby producing pattern profiles with minimal white edges.

### BRIEF DESCRIPTION OF THE DRAWINGS

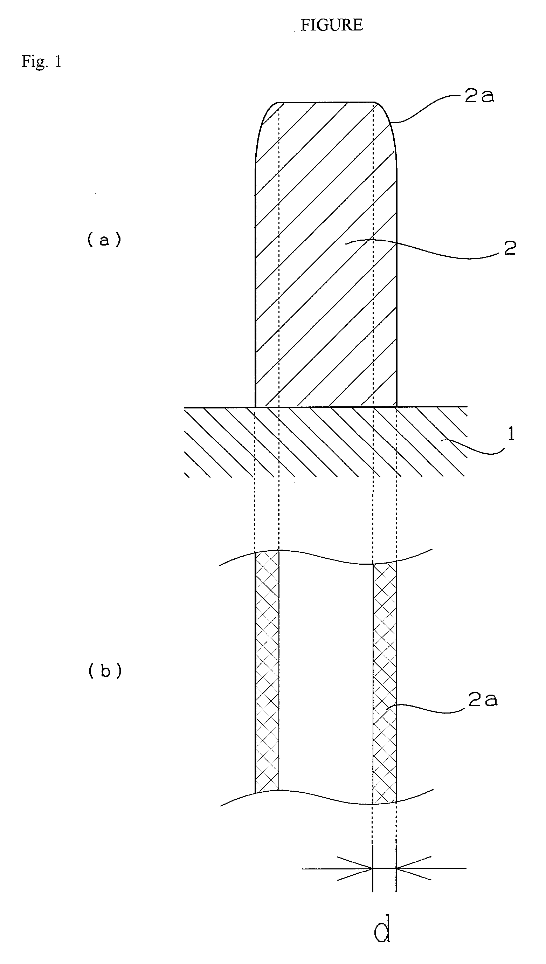

Fig. 1 is schematic views of pattern profiles.

### DETAILED DESCRIPTION OF THE PREFERRED EMBODIMENTS

The acid-labile group-containing resin (A) is a copolymer prepared by anionic polymerization of monomers including a substituted or unsubstituted styrene and have a terminal group shown by the following formula (x). 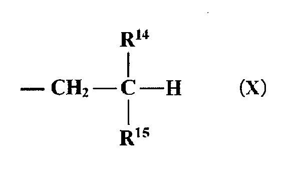 wherein R¹⁴ and R¹⁵ individually represent a hydrogen atom or a linear or branched saturated hydrocarbon group having 1-6 carbon atoms.

As examples of the linear or branched saturated hydrocarbon group having 1-6 carbon atoms represented by R¹⁴ or R¹⁵ in the above formula (x), alkyl groups such as a methyl group, ethyl group, n-propyl group, i-propyl group, n-butyl group, 2-methylpropyl group, 1-methylpropyl group, t-butyl group, n-pentyl group, iso-pentyl group, n-heptyl group, iso-heptyl group, n-hexyl group, iso-hexyl group, and the like can be given.

A methyl group and an ethyl group are preferable as the above saturated hydrocarbon group. Preferable examples of the formula (x) are shown by the following formula (x-1) or (x-2).

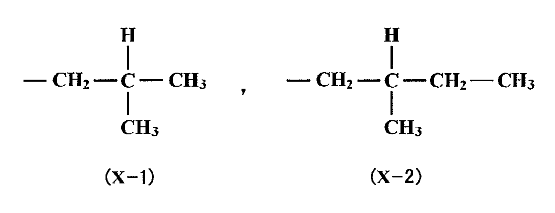

The terminal group of the formula (x) can be introduced at the end of the copolymerization reaction by reacting the copolymer with a halogenated hydrocarbon with a halogen substituted at the terminal of the formula (X). Such a halogenated hydrocarbon acts as a polymerization terminator in the polymerization reaction. A preferable polymerization terminator is shown by the following formula (x-3). 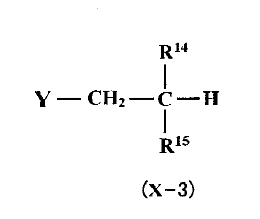 wherein R¹⁴ and R¹⁵ individually represent a hydrogen atom or linear or branched saturated hydrocarbon group having 1-6 carbon atoms, and Y represents iodine atom or bromine atom.

As examples of the polymerization terminator, compounds of the formula (x-1) or (x-2), in which the terminal is replaced with iodine atom or bromine atom, can be given.

Specific examples of the polymerization terminator include ethyl bromide, isobutyl iodide, isopentyl iodide, and the like.

R² and R³ in the monomer of the formula (1) represent saturated hydrocarbon groups having 1-4 carbon atoms or bond together to form a cyclic ether group having 3-7 carbon atoms.

As examples of the saturated hydrocarbon groups having 1-4 carbon atoms, alkyl groups such as a methyl group, ethyl group, n-propyl group, i-propyl group, n-butyl group, 2-methylpropyl group, 1-methylpropyl group, and t-butyl group can be given.

Examples of the cyclic ether having 3-7 carbon atoms include a tetrahydrofuranyl group, tetrahydropyranyl group, and the like.

As suitable monomers shown by the formula (1), p-(ethoxy)ethoxystyrene, tetrahydroxyfuranyloxystyrene, tetrahydropyranyloxystyrene, and the like can be given.

As the recurring unit having an acid-labile group, recurring units obtainable from a recurring unit derived by cleavage of a polymerizable unsaturated bond in a recurring unit having one or more acidic functional groups such as a phenolic hydroxyl group or carboxyl group, by replacing a hydrogen atom in the phenolic hydroxyl group or carboxyl group with an acid-labile group, can be given. Of these, the recurring unit obtained by replacing the hydrogen atom in a phenolic hydroxyl group with an acid-labile group is preferable, with a recurring unit prepared by copolymerizing a monomer of the formula (2) being particularly preferable.

R⁴, R⁵, and R⁶ in the formula (2) represent saturated hydrocarbon groups having 1-4 carbon atoms. As examples of the saturated hydrocarbon groups having 1-4 carbon atoms, monovalent alkyl groups such as a methyl group, ethyl group, n-propyl group, i-propyl group, n-butyl group, 2-methylpropyl group, 1-methylpropyl group, and t-butyl group can be given.

As suitable monomers shown by the formula (2), p-t-butoxystyrene, m-t-butoxystyrene, p-t-amyloxystyrene, p-1-methoxycyclohexyloxystyrene, p-1-ethylcyclohexyloxystyrene, p-1-methylcyclopentyloxystyrene, p-1-ethylcyclopentyloxystyrene, and the like can be given.

The above copolymer may further comprise monomers other than the monomers of the formula (1) and the monomers forming the recurring unit (A2). As examples, styrene, α-methylstyrene, 4-methylstyrene, 2-methylstyrene, 3-methylstyrene, isobornyl acrylate, tricyclodecanyl (meth)acrylate, tetracyclododecenyl (meth)acrylate, and the like can be given. Of these, styrene, α-methylstyrene, 4-methylstyrene, 2-methylstyrene, 3-methylstyrene, and tricyclodecanyl acrylate are preferable.

Taking the balance of the resolution and dry etching resistance into consideration, the proportion of such monomers is usually 20 mol% or less.

As the method for copolymerizing monomers including the monomers of the formula (1) and the monomers forming the recurring unit (A2), anionic polymerization is preferable due to easy control of the copolymer structure.

The anionic polymerization can be carried out as follows, for example. The monomers are stirred in a suitable organic solvent in the presence of an anionic polymerization initiator in a nitrogen atmosphere while maintaining the temperature at -100°C to 120°C for 0.5 to 24 hours, for example.

As the solvent, any hydrocarbon solvents or polar solvents may be used. As examples of the hydrocarbon solvent, pentane, hexane, heptane, octane, methylcyclopentane, cyclohexane, benzene, toluene, and xylene can be given.

In the polymerization using a hydrocarbon solvent, ether compounds such as diethyl ether, di-n-butyl ether, ethylene glycol diethyl ether, ethylene glycol dibutyl ether, ethylene glycol dimethyl ether, propylene glycol dimethyl ether, propylene glycol diethyl ether, propylene glycol dibutyl ether, tetrahydrofuran, 2,2-(bistetrahydrofurfuryl)propane, bistetrahydrofurfurylformal, methyl ether of bistetrahydrofurfuryl alcohol, ethyl ether of bistetrahydrofurfuryl alcohol, butyl ether of bistetrahydrofurfuryl alcohol, α-methoxytetrahydrofuran, dimethoxybenzene, and dimethoxyethane and/or tertiary amine compounds such as triethylamine, pyridine, N,N,N',N'-tetramethyl ethylenediamine, dipiperidinoethane, methyl ether of N,N-diethylethanolamine, ethyl ether of N,N-diethylethanolamine, and butyl ether of N,N-diethylethanolamine may be added, as appropriate.

As examples of the polar solvent, ether compounds such as diethyl ether, tetrahydrofuran, dioxane, and trioxane, tertiary amines such as tetramethylethylenediamine (TMEDA) and hexamethylphosphoric triamide (HMPA), and the like can be given.

These hydrocarbon solvents and polar solvents may be used either individually or in combination of two or more.

As the anionic polymerization initiator, an organic alkali metal such as n-butyllithium, s-butyllithium, t-butyllithium, ethyllithium, ethylsodium, phenyllithium, lithium naphthalene, sodium naphthalene, potassium naphthalene, lithium stilbene, 1,1-diphenylhexyllithium, 1,1-diphenyl-3-methylpentyllithium, and the like can be used.

At the end of the polymerization reaction, a halogenated hydrocarbon such as ethyl bromide, isobutyl iodide, or isopentyl iodide is reacted to introduce the group shown by the formula (x) to the molecular chain terminals.

After the copolymerization, the side chains of the monomer of the formula (1) are selectively hydrolyzed to produce the copolymer containing a recurring unit having a phenolic hydroxyl group on the side chain (A1) and a recurring unit having an acid-labile group (A2).

Either all side chains of the monomer of the formula (1) may be hydrolyzed or 30 mol% or less side chains of the monomer of the formula (1) may be allowed to remain. Preferably, no side chains are left without being hydrolyzed.

A method and conditions for selectively hydrolyzing the side chain of the monomer of the formula (1) will now be explained.

An acid catalyst is used in the hydrolysis reaction. As examples of the acid catalyst used in the hydrolysis reaction, hydrochloric acid and sulfuric acid, as well as organic acids such as p-toluenesulfonic acid and its hydrate, methanesulfonic acid, trifluoromethanesulfonic acid, malonic acid, oxalic acid, 1,1,1-trifluoroacetic acid, acetic acid, p-toluenesulfonic acid pyridinium salt, and the like can be given.

As examples of suitable organic solvents used in the hydrolysis reaction, ketones such as acetone, methyl ethyl ketone, and methyl amyl ketone; ethers such as diethyl ether and tetrahydrofuran (THF); alcohols such as methanol, ethanol, and propanol; aliphatic hydrocarbons such as hexane, heptane, and octane; aromatic hydrocarbons such as benzene, toluene, and xylene; alkyl halides such as chloroform, bromoform, methylene chloride, methylene bromide, and carbon tetrachloride; esters such as ethyl acetate, butyl acetate, ethyl lactate, propylene glycol monomethyl ether, propylene glycol monomethyl ether acetate, and cellosolve; aprotic polar solvent such as dimethylformamide, dimethyl sulfoxide, hexamethylphosphoroamide, and the like can be given. Of these, acetone, methyl amyl ketone, methyl ethyl ketone, tetrahydrofuran, methanol, ethanol, propanol, ethyl acetate, butyl acetate, ethyl lactate, propylene glycol monomethyl ether, propylene glycol monomethyl ether acetate, and the like are particularly preferable.

The hydrolysis conditions include the concentration of 1 to 50 wt%, preferably 3 to 40 wt%, and more preferably 5 to 30 wt%; the temperature of -20 to 80°C, preferably 0 to 60°C, and more preferably 5 to 40°C, and the reaction time, which may vary according to the temperature, is in the range from 10 minutes to 20 hours, preferably 30 minutes to 10 hours, and more preferably 1 to 6 hours.

The hydrolysis reaction is carried out by dissolving the copolymer in an organic solvent, adding an acid catalyst, and stirring the mixture.

The proportion of the recurring unit (A1) having a phenolic hydroxyl group on the side chain in the copolymer is usually 40-90 mol%, preferably 50-85 mol%, and more preferably 60-80 mol%.

The proportion of the recurring unit (A2) having an acid-labile group on the side chain is usually 5-50 mol%, preferably 10-40 mol%, and more preferably 15-35 mol%. The proportion of the recurring unit (2) is usually 5-50 mol%, preferably 10-40 mol%, and more preferably 15-35 mol%.

The above proportion of recurring units not only ensures improved resolution, sensitivity, and focal depth allowance (process margin), but also eliminates development residues during formation of resist patterns. In addition, profile with minimal white edges can be produced.

The polystyrene-reduced weight average molecular weight (hereinafter referred to from time to time as "Mw") of the copolymer determined by gel permeation chromatography (GPC) is 1,000 to 150,000, preferably 3,000 to 30,000, more preferably 3,500 to 20,000, and particularly preferably 4,000 to 17,000. The ratio of Mw to the polystyrene-reduced number average molecular weight measured by GPC (hereinafter referred to from time to time as "Mn") (Mw/Mn) is usually 1 to 5.

As the photoacid generator (hereinafter referred to as "acid generator") generating an acid upon exposure to light, (1) sulfonimide compounds, (2) disulfonylmethane compounds, (3) onium salt compounds, (4) sulfone compounds, (5) sulfonic acid ester compounds, (6) diazomethane compounds, and the like can be given.

The example of the acid generator is described below.

### (1) sulfonimide compound

As an example of the sulfonimide compound, a compound of the following formula (3) can be given. 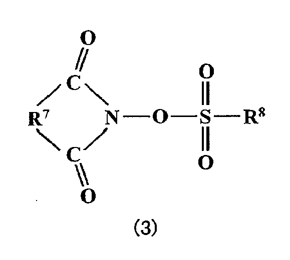 wherein R⁸ is a monovalent organic group and R⁷ is a divalent organic group.

As the monovalent organic group, a substituted or unsubstituted linear or branched alkyl group, substituted or unsubstituted cyclic alkyl group, substituted or unsubstituted aryl group, perfluoroalkyl group, and the like can be given. As the divalent organic group, a substituted or unsubstituted alkylene group, substituted or unsubstituted alkenylene group, substituted or unsubstituted phenylene group, and the like can be given.

As specific examples of the sulfonimide compound,
N-(trifluoromethylsulfonyloxy) succinimide,
N-(trifluoromethylsulfonyloxy)bicyclo[2.2.1]hept-5-ene-2,3-dicarboxyimide,
N-(10-camphorsulfonyloxy) succinimide,
N-(10-camphorsulfonyloxy)bicyclo[2.2.1]hept-5-ene-2,3-dicarboxyimide,
N-(10-camphorsulfonyloxy)-7-oxabicyclo[2.2.1]hept-5-ene-2,3-dicarboxyimide,
N-(4-methylphenylsulfonyloxy) succinimide,
N-(4-methylphenylfonyloxy)bicyclo[2.2.1]hept-5-ene-2,3-dicarboxyimide,
N-(4-trifluoromethylphenylsulfonyloxy)succinimide,
N-(4-trifluoromethylphenylsulfonyloxy) bicyclo[2.2.1]hept-5-ene-2,3-dicarboxyimide,
N-(perfluorophenylsulfonyloxy)succinimide,
N-(perfluorophenylsulfonyloxy)bicyclo[2.2.1]hept-5-ene-2,3-dicarboxyimide,
N-(nonafluorobutylsulfonyloxy)succinimide,
N-(nonafluorobutylsulfonyloxy)bicyclo[2.2.1]hept-5-ene-2,3-dicarboxyimide,
N-(perfluorooctylsulfonyloxy)succinimide,
N-(perfluorooctylsulfonyloxy)bicyclo[2.2.1]hept-5-ene-2,3-dicarboxyimide,
N-(phenylsulfonyloxy)succinimide,
N-(phenylsulfonyloxy)bicyclo[2.2.1]hept-5-ene-2,3-dicarboxyimide,
N-(phenylsulfonyloxy)-7-oxabicyclo[2.2.1]hept-5-ene-2,3-dicarboxyimide,
N-{(5-methyl-5-carboxymethane bicyclo[2.2.1]hepta-2-yl) sulfonyloxy} succinimide, and the like can be given.

Of these sulfonimide compounds,
N-(trifluoromethylsulfonyloxy)bicyclo[2.2.1]hept-5-ene-2,3-dicarboxyimide,
N-(10-camphorsulfonyloxy) succinimide, N-(p-toluenesulfonyloxy) succinimide,
N-(nonafluorobutylsulfonyloxy)bicyclo[2.2.1]hept-5-ene-2,3-dicarboxyimide,
N-(phenylsulfonyloxy)bicyclo[2.2.1]hept-5-ene-2,3-dicarboxyimide,
N-{(5-methyl-5-carboxymethyl bicyclo[2.2.1]hepta-2-yl) sulfonyloxy} succinimide are preferable.

### (2) disulfonylmethane compound

As an example of the disulfonylmethane compound, a compound of the following formula (4) can be given. 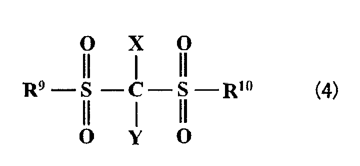 wherein R⁹ and R¹⁰ individually represent a linear or branched aliphatic hydrocarbon group, a cycloalkyl group, an aryl group, an aralkyl group, and a monovalent other organic group having a hetero atom, X and Y individually represent an aryl group, a hydrogen atom, a linear or branched monovalent aliphatic hydrocarbon group, and a monovalent other organic group having a hetero atom, at least one of X and Y represents an aryl group, or X and Y bond together to form a monocyclic or polycyclic carbon ring having a unsaturated bond, or X and Y bond together to form a group of the following formula (4-1). 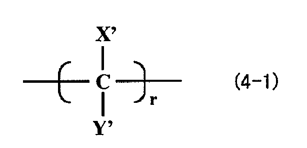 wherein X' and Y' individually represent a hydrogen atom, a halogen atom, a linear or branched alkyl group, cycloalkyl group, an aryl group, and an aralkyl group, or X' and Y' , each bonding to the same or different carbon atom, bond together to form a monocyclic carbon ring, one or more X' and Y' individually represent same or different, and r represents an integer of 2-10.

### (3) onium salt compound

As the onium salt compound, for example, iodonium salt, sulfonium salt, phosphonium salt, diazonium salt, ammonium salt, pyridinium salt, and the like can be given.

As specific examples of the onium salt compound, bis(4-t-butylphenyl)iodonium nonafluorobutanesulfonate, bis(4-t-butylphenyl)iodonium trifluoromethanesulfonate, bis(4-t-butylphenyl)iodonium perfluorooctanesulfonate, bis(4-t-butylphenyl)iodonium p-toluenesulfonate, bis(4-t-butylphenyl)iodonium 10-camphorsulfonate, 4-trifluoromethylbenzenesulfonate, bis(4-t-butylphenyl)iodonium perfluorobenzenesulfonate, diphenyliodonium nonafluorobutanesulfonate, diphenyliodonium trifluoromethanesulfonate, diphenyliodonium perfluorooctanesulfonate, diphenyliodonium p-toluenesulfonate, diphenyliodonium benzenesulfonate, diphenyliodonium 10-camphorsulfonate, diphenyliodonium 4-trifluoromethylbenzenesulfonate, diphenyliodonium perfluorobenzenesulfonate, triphenylsulfonium nonafluorobutanesulfonate, triphenylsulfonium trifluoromethanesulfonate, triphenylsulfonium perfluorooctanesulfonate, triphenylsulfonium p-toluenesulfonate, triphenylsulfonium benzenesulfonate, triphenylsulfonium 10-camphorsulfonate, triphenylsulfonium 4-trifluoromethylbenzenesulfonate, triphenylsulfonium perfluorobenzenesulfonate, 4-hydroxyphenyl diphenylsulfonium trifluoromethanesulfonate, tris(p-methoxyphenyl)sulfonium nonafluorobutanesulfonate, tris(p-methoxyphenyl)sulfonium trifluoromethanesulfonate, tris(p-methoxyphenyl)sulfonium perfluorooctanesulfonate, tris(p-methoxyphenyl)sulfonium p-toluenesulfonate, tris(p-methoxyphenyl)sulfonium benzenesulfonate, tris(p-methoxyphenyl)sulfonium 10-camphorsulfonate, bis(p-fluorophenyl)iodonium trifluoromethanesulfonate, bis(p-fluorophenyl)iodonium nonafluoromethanesulfonate, bis(p-fluorophenyl)iodonium 10-camphorsulfonate, (p-fluorophenyl)(phenyl)iodonium trifluoromethanesulfonate, tris(p-fluorophenyl)sulfonium trifluoromethanesulfonate, tris(p-fluorophenyl)sulfonium p-toluenesulfonate, (p-fluorophenyl)diphenylsulfonium trifluoromethanesulfonate, 2,4,6-trimethylphenyl diphenylsulfonium 2,4-difluorobenzenesulfonate, 2,4,6-trimethylphenyl diphenylsulfonium 4-trifluoromethylbenzenesulfonate, and the like can be given.

### (4) sulfone compound

As an example of the sulfone compound, β-ketosulfone, β-sulfonylsulfone, and α-diazo compounds of these compounds, and the like can be given.

As specific examples of the sulfone compound, phenacylphenylsulfone, mesitylphenylsulfone, bis(phenylsulfonyl)methane, 4-trisphenacylsulfone, and the like can be given.

### (5) sulfonic acid ester compound

As an example of the sulfonic acid ester compound, alkyl sulfonic acid ester, haloalkyl sulfonic acid ester, aryl sulfonic acid ester, imino sulfonate, and the like can be given.

As specific examples of the sulfonic acid ester compound, benzointosylate, pyrogallol tris(trifluoromethanesulfonate), pyrogallol tris(nonafluoro-n-butanesulfonate), pyrogallol tris(methanesulfonate), nitrobenzyl-9,10-diethoxyanthracene-2-sulfonate, α -methylolbenzointosylate, α-methylolbenzoin n-octanesulfonate, α-methylol benzoin trifluoromethanesulfonate, α-methylolbenzoin n-dodecanesulfonate, and the like can be given.

### (6) diazomethane compound

As an example of the diazomethane compound, a compound of the following formula (5) can be given. 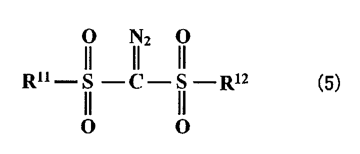 wherein R¹¹ and R¹² is individually represent monovalent group such as an alkyl group, an aryl group, a halogenated alkyl group, a halogenated aryl group, and the like.

As specific examples of the diazomethane compound, bis(trifluoromethylsulfonyl) diazomethane, bis(cyclohexylsulfonyl) diazomethane, bis(phenylsulfonyl) diazomethane, bis(4-methylphenylsulfonyl) diazomethane, methylsulfonyl- 4-methylphenylsulfonyl diazomethane, cyclohexylsulfonyl-1,1-dimethylethylsulfonyl diazomethane, bis(1,1-dimethylethylsulfonyl) diazomethane, bis(3,3-dimethyl-1,5-dioxaspiro[5,5]dodecane-8-sulfonyl) diazomethane, bis(1,4-dioxaspiro [4,5]decane-7-sulfonyl) diazomethane, bis(t-butylsulfonyl) diazomethane, and the like can be given.

As the preferable acid generator, at least one of the compounds selected from sulfonimide compounds, onium salt compounds, and diazomethane compounds can be given. Particularly preferable examples of the acid generator is sulfonimide compound and containing the sulfonimide compound as essential components is particularly preferable in the present invention. It is because that better pattern profiles can be obtained by combining with the sulfonimide compound which is a nonionic acid generator.

As specific examples of the preferable acid generator, sulfonimide compounds such as N-(trifluoromethylsulfonyloxy)succinimide, N-(trifluoromethylsulfonyloxy) bicyclo[2.2.1]hept-5-ene-2,3-dicarboxyimide, N-(10-camphorsulfonyloxy) succinimide, N-(10-camphorsulfonyloxy)bicyclo[2.2.1]hept-5-ene-2,3-dicarboxyimide, N-{(5-methyl-5-carboxymethyl bicyclo[2.2.1]hepta-2-yl) sulfonyloxy} succinimide, N-(nonafluorobutylsulfonyloxy) bicyclo[2.2.1]hept-5-ene-2,3-dicarboxyimide, N-(4-methylphenyl sulfonyloxy) succinimide, and N-(phenylsulfonyloxy)bicyclo[2.2.1]hept-5-ene-2,3-dicarboxyimide; onium salts such as bis(4-t-butylphenyl)iodonium trifluoromethane sulfonate, bis(4-t-butylphenyl)iodonium perfluoro-n-butanesulfonate, bis(4-t-butylphenyl)iodonium p-toluenesulfonate, bis(4-t-butylphenyl)iodonium 10-camphorsulfonate, bis(4-t-butylphenyl)iodonium 2-trifluoromethylbenzenesulfonate, bis(4-t-butylphenyl)iodonium 4-trifluoromethylbenzenesulfonate, bis(4-t-butylphenyl)iodonium 2,4-difluorobenzenesulfonate, triphenylsulfonium trifluoromethanesulfonate, triphenylsulfonium perfluoro-n-butanesulfonate, triphenylsulfonium p-toluenesulfonate, triphenylsulfonium 10-camphorsulfonate, triphenylsulfonium 2-trifluoromethylbenzenesulfonate, triphenylsulfonium 4-trifluorobenzenesulfonate, triphenylsulfonium 2,4-difluoromethylbenzenesulfonate, bis(4-t-butylphenyl)iodonium perfluorooctanesulfonate, diphenyliodonium nonafluorobutanesulfonate, diphenyliodonium trifluoromethanesulfonate, diphenyliodonium perfluorooctanesulfonate, diphenyliodonium 10-camphorsulfonate, triphenylsulfonium perfluorooctanesulfonate, tris(p-methoxyphenyl)sulfonium trifluoromethanesulfonate, tris(p-methoxyphenyl)sulfonium 10-camphorsulfonate, bis(p-fluorophenyl)iodonium trifluoromethanesulfonate, bis(p-fluorophenyl)iodonium nonafluoromethanesulfonate, bis(p-fluorophenyl)iodonium 10-camphorsulfonate, (p-fluorophenyl)(phenyl)iodonium trifluoromethanesulfonate, tris(p-fluorophenyl)sulfonium trifluoromethanesulfonate, tris(p-fluorophenyl)sulfonium p-toluenesulfonate, (p-fluorophenyl)diphenylsulfonium trifluoromethanesulfonate, 2,4,6-trimethylphenyl diphenylsulfonium 2,4-difluorobenzenesulfonate, and 2,4,6-trimethylphenyl diphenylsulfonium 4-trifluoromethylbenzenesulfonate; diazomethane compounds such as bis(cyclohexylsulfonyl) diazomethane, bis(3,3-dimethyl-1,5- dioxaspiro [5,5]dodecane-8-sulfonyl) diazomethane, bis(1,4-dioxaspiro [4,5]decane-7-sulfonyl) diazomethane, and bis(t-butylsulfonyl) diazomethane; can be given.

In the present invention, the amount of acid generator to be used is usually from 0.1 to 20 parts by weight, and preferably from 0.5 to 15 parts by weight for 100 parts by weight of the resin. The acid generators can be used in combination of two or more.

It is preferable to add an alkali-soluble resins, acid diffusion controllers, and other additives to the radiation-sensitive resin composition of the present invention.

Examples of the alkali-soluble resin, poly(p-hydroxystyrene), partially hydrogenated poly(p-hydroxystyrene), poly(m-hydroxystyrene), poly(m-hydroxystyrene), (p-hydroxystyrene)-(m-hydroxystyrene) copolymer, (p-hydroxystyrene)-(styrene) copolymer, novolac resin, polyvinyl alcohol, polyacrylic acid, and the like can be given. The Mw of the resin is from 1,000 to 1,000,000, preferably from 2,000 to 100,000. The alkali-soluble resins can be used either individually or in combinations of two or more.

The amount of the alkali-soluble resin to be added is usually 30 parts by weight or less for 100 parts by weight of the resin.

The acid diffusion controllers control diffusion of an acid generated from the acid generator upon exposure in the resist film to suppress undesired chemical reactions in the unexposed area. Addition of the acid diffusion controller further improves storage stability of the resulting composition and resolution of the resist. Moreover, the addition of the acid diffusion controller prevents the line width of the resist pattern from changing due to changes in the post-exposure delay (PED), whereby a composition with remarkably superior process stability can be obtained.

As the acid diffusion controller, nitrogen-containing organic compounds of which the basicity does not change during exposure or heating when forming a resist pattern are preferable.

As examples of the nitrogen-containing organic compound, a compound of the following formula (6) (hereinafter referred to as "nitrogen-containing compound (I)"), a diamino compound having two nitrogen atoms in the molecule (hereinafter referred to as "nitrogen-containing compound (II)"), a diamino polymer having three or more nitrogen atoms (hereinafter referred to as "nitrogen-containing compound (III)"), amide group-containing compounds, urea compounds, and nitrogen-containing heterocyclic compounds can be given. 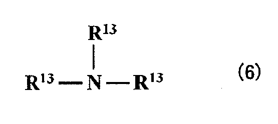 wherein R¹³ individually represent same or different, a hydrogen atom, an alkyl group, an aryl group, and aralkyl group, which may be substituted by functional group such as an hydroxy group, for a hydrogen atom of the alkyl group, the aryl group, and the aralkyl group.

As examples of the nitrogen-containing compound (I), monoalkylamines such as n-hexylamine, n- heptylamine, n- octylamine, n- nonylamine, and n-decylamine; dialkylamines such as di-n-butylamine, di-n-pentylamine, di-n-hexylamine, di-n-heptylamine, di-n-octylamine, di-n-nonylamine, and di-n-decylamine; trialkylamines such as triethylamine, tri-n-propylamine, tri-n-butylamine, tri-n-pentylamine, tri-n-hexylamine, tri-n-heptylamine, tri-n-octylamine, tri-n-nonylamine, and tri-n-decylamine; aromatic amines such as aniline, N-methylaniline, N,N-dimethylaniline, 2-methylaniline, 3-methylaniline, 4-methylaniline, 4-nitroaniline, diphenylamine, triphenylamine, and 1-naphthylamine; and the like can be given.

As examples of the nitrogen-containing compound (II), ethylenediamine, N,N,N',N'-tetramethylethylenediamine, N,N,N',N'-tetrakis(2-hydroxypropyl)ethylenediamine, tetramethylenediamine, hexamethylenediamine, 4,4'-diaminodiphenylmethane, 4,4'-diaminodiphenyl ether, 4,4'-diaminobenzophenone, 4,4'-diaminodiphenylamine, 2,2'-bis(4-aminophenyl)propane, 2-(3-aminophenyl)-2-(4-aminophenyl) propane, 2-(4-aminophenyl)-2-(3- hydroxylphenyl) propane, 2-(4-aminophenyl)-2-(4-hydroxylphenyl)propane, 1,4-bis[ 1-(4-aminophenyl)-1-methylethyl]benzene, 1,3-bis[1-(4-aminophenyl)-1-methylethyl]benzene, and the like can be given.

As examples of the nitrogen-containing compound (III), polyethyleneimine, polyallylamine, polymer of dimethylaminoethyl acrylamide, and the like can be given.

As examples of the amide group-containing compounds, formamide, N-methylformamide, N,N-dimethylformamide, acetamide, N-methylacetamide, N,N-dimethylacetamide, propionamide, benzamide, pyrrolidone, N-methylpyrrolidone, and the like can be given.

As examples of the urea compounds, urea, methylurea, 1,1-dimethylurea, 1,3-dimethylurea, 1,1,3,3-tetramethylurea, 1,3-diphenylurea, tributylthiourea, and the like can be given.

As examples of the nitrogen-containing heterocyclic compounds, imidazoles such as imidazole, benzimidazole, 4-methylimidazole, 4-methyl-2-phenylimidazole, and 2-phenylbenzimidazole; pyridines such as pyridine, 2-methylpyridine, 4-methylpyridine, 2-ethylpyridine, 4-ethylpyridine, 2-phenylpyridine, 4-phenylpyridine, N-methyl-4-phenylpyridine, nicotine, nicotinic acid, nicotinamide, quinoline, 8-oxyquinoline, and acridine; and pyrazine, pyrazole, pyridazine, quinoxaline, purine, pyrrolidine, piperidine, morpholine, 4-methylmorpholine, piperazine, 1,4-dimethylpiperazine, and 1,4-diazabicyclo[2.2.2]octane, and the like can be given.

Base precursor having acid-labile group may be added as acid diffusion controller. Examples of the base precursors, N-(t-butoxycarbonyl) piperidine, N-(t-butoxycarbonyl) imidazole, N-(t-butoxycarbonyl) benzimidazole, N-(t-butoxycarbonyl) 2-phenylbenzimidazole, N-(t-butoxycarbonyl) dioctylamine, N-(t-butoxycarbonyl) diethanolamine, N-(t-butoxycarbonyl) dicyclohexylamine, N-(t-butoxycarbonyl) diphenylamine, and the like can be given.

Of these nitrogen-containing organic compounds, the nitrogen-containing compounds (I) and nitrogen-containing heterocyclic compounds are preferable. Among the nitrogen-containing compounds (I), trialkylamines are particularly preferable. Among the nitrogen-containing heterocyclic compounds, imidazoles are particularly preferable.

The acid diffusion controller can be used either individually or in combination of two or more.

The amount of the acid diffusion controller to be added is usually 15 parts by weight or less, preferably 0.001 to 10 parts by weight, and still more preferably 0.005 to 5 parts by weight for 100 parts by weight of the resin. If the amount of the acid diffusion controller exceeds 15 parts by weight, sensitivity as a resist and developability of the exposed area tend to decrease. If the amount is less than 0.001 parts by weight, the pattern profile or dimensional accuracy as a resist may decrease depending on the processing conditions.

Surfactants exhibiting an action of improving the applicability or striation of the composition and developability as resist may optionally be added to the radiation-sensitive resin composition of the present invention.

As examples of the surfactant, polyoxyethylene lauryl ether, polyoxyethylene stearyl ether, polyoxyethylene oleyl ether, polyoxyethylene octyl phenol ether, polyoxyethylene nonyl phenol ether, polyethylene glycol dilaurate, polyethylene glycol distearate, and commercially available products such as FTOP EF301, EF303, EF352 (manufactured by Tohkem Products Corporation), MEGAFAC F171, F173 (manufactured by Dainippon Ink and Chemicals, Inc.), Fluorad FC430, FC431 (manufactured by Sumitomo 3M Ltd.), Asahi Guard AG710, and Surflon S-382, SC-101, SC-102, SC-103, SC-104, SC-105, SC-106 (manufactured by Asahi Glass Co., Ltd.), KP341 (manufactured by Shin-Etsu Chemical Co., Ltd.), and POLYFLOW No. 75, No. 95 (manufactured by Kyoeisha Chemical Co., Ltd.) can be given.

The amount of surfactants to be added is usually two parts by weight or less for 100 parts by weight of the acid-labile group-containing resin.

Other sensitizers may optionally be added to the radiation-sensitive resin composition of the present invention. As preferable examples of sensitizers, carbazoles, benzophenones, rose bengals, and anthracenes can be given.

The amount of sensitizers to be added is preferably 50 parts by weight or less for 100 parts by weight of the resin.

In addition, a dye and/or a pigment may be added to visualize latent image of exposed area and to reduce the effects of halation during exposure. Addition of the adhesion promoters further improves adhesion to the substrate.

As examples of other additives, halation inhibitors such as 4-hydroxy-4'-methylchalcone, form improvers, storage stabilizers, anti-foaming agents, and the like can be given.

When using, the radiation-sensitive resin composition of the present invention is made into a composition solution by dissolving the composition in a solvent so that the total solid content is usually from 0.1 to 50 wt%, and preferably from 1 to 40 wt%, and filtering the solution using a filter with a pore diameter of about 200nm, for example.

As examples of solvents used for preparation of the composition solution, ethylene glycol monoalkyl ether acetates such as ethylene glycol monomethyl ether acetate, ethylene glycol monoethyl ether acetate, ethylene glycol mono-n-propyl ether acetate, and ethylene glycol mono-n-butyl ether acetate; propylene glycol monoalkyl ethers such as propylene glycol monomethyl ether, propylene glycol monoethyl ether, propylene glycol mono-n-propyl ether, and propylene glycol mono-n-butyl ether; propylene glycol dialkyl ethers such as propylene glycol dimethyl ether, propylene glycol diethyl ether, propylene glycol di-n-propyl ether, and propylene glycol di-n-butyl ether; propylene glycol monoalkyl ether acetates such as propylene glycol monomethyl ether acetate, propylene glycol monoethyl ether acetate, propylene glycol mono-n-propyl ether acetate, and propylene glycol mono-n-butyl ether acetate; lactic acid esters such as methyl lactate, ethyl lactate, n-propyl lactate, and i-propyl lactate; aliphatic carboxylic acid esters such as n-amyl formate, i-amyl formate, ethyl acetate, n-propyl acetate, i-propyl acetate, n-butyl acetate, i-butyl acetate, n-amyl acetate, i-amyl acetate, i-propyl propionate, n-butyl propionate, and i-butyl propionate; other esters such as ethyl hydroxyacetate, ethyl 2-hydroxy-2-methylpropionate, methyl 2-hydroxy-3-methylbutyrate, ethyl methoxyacetate, ethyl ethoxyacetate, methyl 3-methoxypropionate, ethyl 3-methoxypropionate, methyl 3-ethoxypropionate, ethyl 3-ethoxypropionate, butyl 3-methoxyacetate, butyl 3-methyl-3-methoxyacetate, butyl 3-methyl-3-methoxypropionate, butyl 3-methyl-3-methoxybutylate, methyl acetoacetate, ethyl acetoacetate, methyl pyruvate, and ethyl pyruvate; aromatic hydrocarbons such as toluene, and xylene; ketones such as methyl ethyl ketone, methyl propyl ketone, methyl butyl ketone, 2-heptanone, 3-heptanone, 4-heptanone, and cyclohexanone; amides such as N-methylformamide, N,N-dimethylformamide, N-methylacetamide, N,N-dimethylacetamide, and N-methylpyrrolidone; lactones such as γ-butyrolactone, and the like can be given.

These solvents may be used either individually or in combination of two or more.

A resist pattern is formed from the radiation-sensitive resin composition of the present invention by applying the composition solution prepared as mentioned above to substrates such as a silicon wafer and a wafer coated with aluminum using an appropriate application method such as spin coating, cast coating, and roll coating to form a resist film. The resist film is then optionally pre-baked (hereinafter called "PB") with temperature about 70°C to 160°C and exposed with radiation through a specific mask pattern. As the radiation, deep ultraviolet rays such as F₂ excimer laser (wavelength: 157 nm), ArF excimer laser (wavelength: 193 nm), and KrF excimer laser (wavelength: 248 nm), X-rays such as synchrotron radiation, or charged particle rays such as electron beams may be appropriately selected according to the types of acid generator. The exposure conditions such as exposure dosage are appropriately determined depending on the composition of the radiation-sensitive resin composition, types of additives, and the like. Of these, deep ultraviolet rays such as KrF excimer laser (wavelength: 248 nm) or the like are preferable.

It is preferable in the present invention to perform post exposure bake (PEB) with temperature at 70°C to 160°C for 30 seconds or more in order to stably form a highly-accurate minute pattern. If the temperature of the PEB is less than 70 °C, sensitivity may fluctuate according to the type of substrates.

Then, the resist film was developed under the conditions at 10°C to 50°C for 10 to 200 seconds, preferably at 15°C to 30°C for 15 to 100 seconds, and more preferably at 20°C to 25°C for 15 to 90 seconds in an alkaline developer to form a specific resist pattern.

As the alkaline developer, an alkaline aqueous solution prepared by dissolving an alkali compound such as tetraalkyl ammonium hydroxides to a concentration of 1 to 10 wt%, preferably 1 to 5 wt%, and particularly preferably 1 to 3 wt%, for example, may be usually used.

A water-soluble organic solvent such as methanol, ethanol or the like, or a surfactant may be appropriately added to the developer such as the alkaline aqueous solution. When forming a resist pattern, a protection film may be provided on the resist film in order to prevent the effects of basic impurities and the like in an environmental atmosphere.

### EXAMPLES

### Synthesis Example 1

A solvent refluxed for six hours in the presence of sodium metal and after that distilled under nitrogen atmosphere was used. Monomers were used after bubbling dry nitrogen for one hour, followed by distillation. 37.6 g of p-(1-ethoxy)ethoxystyrene, 11.0 g of p-t-butoxystyrene, and 1.4 g of styrene were dissolved in 200 g of cyclohexane. The solution was charged into a dried pressure resistant glass bottle and sealed with a crown cap with a hole having packing made of Neoprene (trade name of E.I. du Pont de Nemours and Company). After cooling the pressure resistant glass bottle to -20°C, 5.92 ml of n-butyllithium (1.83 mol/l cyclohexane solution) and 1.96 g of N,N,N',N'-tetramethylethylenediamine were added in this order. The mixture was reacted for one hour while maintaining the temperature at -20°C. Then, 12.0 g of isobutyl iodide was added to terminate the reaction. The color of the reaction solution was confirmed to turn from red to colorless. After washing with 200 g of 3 wt% oxalic acid-water, 200 g of propylene glycol monomethyl ether and 1.5 g of p-toluenesulfonic acid were added. The mixture was stirred for three hours at room temperature (23-25°C) to be hydrolyzed. The resulting copolymer solution was added dropwise to a large quantity of water to coagulate the copolymer. The produced white powder was filtered and dried overnight at 50°C under reduced pressure.

The copolymer was found to have Mw and Mw/Mn of 8,000 and 1.1 respectively. The result of ¹³C-NMR analysis confirmed that the copolymerization molar ratio of p-hydroxystyrene, styrene, and p-t-butoxystyrene of the copolymer was 72:5:23. This copolymer is referred to as "acid-labile group-containing resin (A-1)".

The Mw and Mn of the copolymer (A-1) and the polymers prepared in the following Synthesis Examples 2-6 were measured by gel permeation chromatography (GPC) using GPC columns (manufactured by Tosoh Corp., G2000H_{XL}×2, G3000H_{XL}×1, G4000H_{XL}×1) under the following conditions. Flow rate: 1.0 ml/minute, eluate: tetrahydrofuran, column temperature: 40°C, standard reference material: monodispersed polystyrene

The terminal structure of the copolymer (A-1) and the polymers prepared in the Synthesis Examples 2-6 was confirmed by ¹³C-NMR analysis.

### Synthesis Example 2

A solvent refluxed for six hours in the presence of sodium metal and after that distilled under nitrogen atmosphere was used. Monomers were used after bubbling dry nitrogen for one hour, followed by distillation. 37.6 g of p-(1-ethoxy) ethoxystyrene, 11.0 g of p-t-butoxystyrene, and 1.4 g of styrene were dissolved in 200 g of cyclohexane. The solution was charged into a dried pressure resistant glass bottle and sealed with a crown cap with a hole having packing made of Neoprene (trade name of E.I. du Pont de Nemours and Company). After cooling the pressure resistant glass bottle to -20°C, 5.92 ml of sec-butyllithium (1.83 mol/l cyclohexane solution) and 1.96 g of N,N,N',N'-tetramethylethylenediamine were added in this order. The mixture was reacted for one hour while maintaining the temperature at -20°C. Then, 12.5 g of isopentyl iodide was added to terminate the reaction. The color of the reaction solution was confirmed to turn from red to colorless. After washing with 200 g of 3 wt% oxalic acid-water, 200 g of propylene glycol monomethyl ether and 0.5g of 35% hydrochloric acid aqueous solution were added. The mixture was stirred for three hours at room temperature (23-25°C) to be hydrolyzed. The resulting copolymer solution was added dropwise to a large quantity of water to coagulate the copolymer. The produced white powder was filtered and dried overnight at 50°C under reduced pressure.

The copolymer was found to have Mw and Mw/Mn of 8,000 and 1.2 respectively. The result of ¹³C-NMR analysis confirmed that the copolymerization molar ratio of p-hydroxystyrene, styrene, and p-t-butoxystyrene of the copolymer was 72:5:23. This copolymer is referred to as "acid-labile group-containing resin (A-2)".

### Synthesis Example 3

A solvent refluxed for six hours in the presence of sodium metal and after that distilled under nitrogen atmosphere was used. Monomers were used after bubbling dry nitrogen for one hour, followed by distillation. 37.6 g of p-(1-ethoxy) ethoxystyrene, 11.0 g of p-t-butoxystyrene, and 4.0 g of styrene were dissolved in 200 g of cyclohexane. The solution was charged into a dried pressure resistant glass bottle and sealed with a crown cap with a hole having packing made of Neoprene (trade name of E.I. du Pont de Nemours and Company). After cooling the pressure resistant glass bottle to -20°C, 9.47 ml of n-butyllithium (1.83 mol/l cyclohexane solution) and 3.14 g of N,N,N',N'-tetramethylethylenediamine were added in this order. The mixture was reacted for one hour while maintaining the temperature at -20°C. Then, 18.4 g of isobutyl iodide was added to terminate the reaction. The color of the reaction solution was confirmed to turn from red to colorless. After washing with 200 g of 3 wt% oxalic acid-water, 200 g of propylene glycol monomethyl ether and 1.5 g of p-toluenesulfonic acid were added. The mixture was stirred for three hours at room temperature (23-25°C) to be partially hydrolyzed p-(1-ethoxy) ethoxystyrene. The resulting copolymer solution was added dropwise to a large quantity of water to coagulate the copolymer. The produced white powder was filtered and dried overnight at 50°C under reduced pressure.

The copolymer was found to have Mw and Mw/Mn of 5,000 and 1.1 respectively. The result of ¹³C-NMR analysis confirmed that the copolymerization molar ratio of p-hydroxystyrene, styrene, and p-t-butoxystyrene of the copolymer was 72:5:23. This copolymer is referred to as "acid-labile group-containing resin (A-3)".

### Synthesis Example 4

A solvent refluxed for six hours in the presence of sodium metal and after that distilled under nitrogen atmosphere was used. Monomers were used after bubbling dry nitrogen for one hour, followed by distillation. 37.6 g of p-(1-ethoxy) ethoxystyrene, 11.0 g of p-t-butoxystyrene, and 1.4 g of styrene were dissolved in 200 g of cyclohexane. The solution was charged into a dried pressure resistant glass bottle and sealed with a crown cap with a hole having packing made of Neoprene (trade name of E.I. du Pont de Nemours and Company). After cooling the pressure resistant glass bottle to -20°C, 5.92 ml of sec-butyllithium (1.83 mol/l cyclohexane solution) and 1.96 g of N,N,N',N'-tetramethylethylenediamine were added in this order. The mixture was reacted for one hour while maintaining the temperature at -20°C. Then, 12.5 g of isopentyl iodide was added to terminate the reaction. The color of the reaction solution was confirmed to turn from red to colorless. After washing with 200 g of 3 wt% oxalic acid-water, 200 g of propylene glycol monomethyl ether and 0.5g of 35% hydrochloric acid aqueous solution were added. The mixture was stirred for one hour at 49-51°C to be hydrolyzed. The resulting copolymer solution was added dropwise to a large quantity of water to coagulate the copolymer. The produced white powder was filtered and dried overnight at 50°C under reduced pressure.

The copolymer was found to have Mw and Mw/Mn of 8,000 and 1.2 respectively. The result of ¹³C-NMR analysis confirmed that the copolymerization molar ratio of p-hydroxystyrene, styrene, and p-t-butoxystyrene of the copolymer was 75:5:20. This copolymer is referred to as "acid-labile group-containing resin (A-4)".

### Synthesis Example 5

A solvent refluxed for six hours in the presence of sodium metal and after that distilled under nitrogen atmosphere was used. Monomers were used after bubbling dry nitrogen for one hour, followed by distillation. 37.6 g of p-(1-ethoxy) ethoxystyrene, 11.0 g of p-t-butoxystyrene, and 1.4 g of styrene were dissolved in 200 g of cyclohexane. The solution was charged into a dried pressure resistant glass bottle and sealed with a crown cap with a hole having packing made of Neoprene (trade name of E.I. du Pont de Nemours and Company). After cooling the pressure resistant glass bottle to -20°C, 3.0 ml of n-butyllithium (1.83 mol/l cyclohexane solution) and 0.98 g of N,N,N',N'-tetramethylethylenediamine were added in this order. The mixture was reacted for one hour while maintaining the temperature at -20°C. Then, 5.8 g of isobutyl iodide was added to terminate the reaction. The color of the reaction solution was confirmed to turn from red to colorless. After washing with 200 g of 3 wt% oxalic acid-water, 200 g of propylene glycol monomethyl ether and 1.5 g of p-toluenesulfonic acid were added. The mixture was stirred for three hours at room temperature (23-25°C) to be hydrolyzed. The resulting copolymer solution was added dropwise to a large quantity of water to coagulate the copolymer. The produced white powder was filtered and dried overnight at 50°C under reduced pressure.

The copolymer was found to have Mw and Mw/Mn of 16,000 and 1.2 respectively. The result of ¹³C-NMR analysis confirmed that the copolymerization molar ratio of p-hydroxystyrene, styrene, and p-t-butoxystyrene of the copolymer was 72:5:23. This copolymer is referred to as "acid-labile group-containing resin (A-5)".

### Synthesis Example 6

A solvent refluxed for six hours in the presence of sodium metal and after that distilled under nitrogen atmosphere was used. Monomers were used after bubbling dry nitrogen for one hour, followed by distillation. 37.6 g of p-(1-ethoxy) ethoxystyrene, 11.0 g of p-t-butoxystyrene, and 1.4 g of styrene were dissolved in 200 g of cyclohexane. The solution was charged into a dried pressure resistant glass bottle and sealed with a crown cap with a hole having packing made of Neoprene (trade name of E.I. du Pont de Nemours and Company). After cooling the pressure resistant glass bottle to -20°C, 4.44 ml of n-butyllithium (1.83 mol/l cyclohexane solution) and 1.47 g of N,N,N',N'-tetramethylethylenediamine were added in this order. The mixture was reacted for one hour while maintaining the temperature at -20°C. Then, 9.38 g of isopentyl iodide was added to terminate the reaction. The color of the reaction solution was confirmed to turn from red to colorless. After washing with 200 g of 3 wt% oxalic acid-water, 200 g of propylene glycol monomethyl ether and 1.5 g of p-toluenesulfonic acid were added. The mixture was stirred for three hours at room temperature (23-25°C) to be hydrolyzed. The resulting copolymer solution was added dropwise to a large quantity of water to coagulate the copolymer. The produced white powder was filtered and dried overnight at 50°C under reduced pressure.

The copolymer was found to have Mw and Mw/Mn of 12,000 and 1.2 respectively. The result of ¹³C-NMR analysis confirmed that the copolymerization molar ratio of p-hydroxystyrene, styrene, and p-t-butoxystyrene of the copolymer was 72:5:23. This copolymer is referred to as "acid-labile group-containing resin (A-6)".

### Comparative Synthesis Example 1

A solvent refluxed for six hours in the presence of sodium metal and after that distilled under nitrogen atmosphere was used. Monomers were used after bubbling dry nitrogen for one hour, followed by distillation. 37.6 g of p-(1-ethoxy)ethoxystyrene, 11.0 g of p-t-butoxystyrene, and 1.4 g of styrene were dissolved in 200 g of cyclohexane. The solution was charged into a dried pressure resistant glass bottle and sealed with a crown cap with a hole having packing made of Neoprene (trade name of E.I. du Pont de Nemours and Company). After cooling the pressure resistant glass bottle to -20°C, 2.96 ml of n-butyllithium (1.83 mol/l cyclohexane solution) and 0.98 g of N,N,N',N'-tetramethylethylenediamine were added in this order. The mixture was reacted for one hour while maintaining the temperature at -20°C. Then, 1.0 g of methanol was added to terminate the reaction. The color of the reaction solution was confirmed to turn from red to colorless. After washing with 200 g of 3 wt% oxalic acid-water, 200 g of propylene glycol monomethyl ether and 1.5 g of p-toluenesulfonic acid were added. The mixture was stirred for three hours at room temperature (23-25°C) to be hydrolyzed. The resulting copolymer solution was added dropwise to a large quantity of water to coagulate the copolymer. The produced white powder was filtered and dried overnight at 50°C under reduced pressure.

The copolymer was found to have Mw and Mw/Mn of 16,000 and 1.3 respectively. The result of ¹³C-NMR analysis confirmed that the copolymerization molar ratio of p-hydroxystyrene, styrene, and p-t-butoxystyrene of the copolymer was 72:5:23. This copolymer is referred to as "acid-labile group-containing resin (α-1)".

### Comparative Synthesis Example 2

A solvent refluxed for six hours in the presence of sodium metal and after that distilled under nitrogen atmosphere was used. Monomers were used after bubbling dry nitrogen for one hour, followed by distillation. 37.6 g of p-(1-ethoxy)ethoxystyrene, 11.0 g of p-t-butoxystyrene, and 1.4 g of styrene were dissolved in 200 g of cyclohexane. The solution was charged into a dried pressure resistant glass bottle and sealed with a crown cap with a hole having packing made of Neoprene (trade name of E.I. du Pont de Nemours and Company). After cooling the pressure resistant glass bottle to -20°C, 4.44 ml of n-butyllithium (1.83 mol/l cyclohexane solution) and 1.47 g of N,N,N',N'-tetramethylethylenediamine were added in this order. The mixture was reacted for one hour while maintaining the temperature at -20°C. Then, 1.5 g of methanol was added to terminate the reaction. The color of the reaction solution was confirmed to turn from red to colorless. After washing with 200 g of 3 wt% oxalic acid-water, 200 g of propylene glycol monomethyl ether and 1.5 g of p-toluenesulfonic acid were added. The mixture was stirred for three hours at room temperature (23-25°C) to be hydrolyzed. The resulting copolymer solution was added dropwise to a large quantity of water to coagulate the copolymer. The produced white powder was filtered and dried overnight at 50°C under reduced pressure.

The copolymer was found to have Mw and Mw/Mn of 12,000 and 1.2 respectively. The result of ¹³C-NMR analysis confirmed that the copolymerization molar ratio of p-hydroxystyrene, styrene, and p-t-butoxystyrene of the copolymer was 72:5:23. This copolymer is referred to as "acid-labile group-containing resin (α-2)".

### Comparative Synthesis Example 3

A solvent refluxed for six hours in the presence of sodium metal and after that distilled under nitrogen atmosphere was used. Monomers were used after bubbling dry nitrogen for one hour, followed by distillation. 37.6 g of p-(1-ethoxy)ethoxystyrene, 11.0 g of p-t-butoxystyrene, and 1.4 g of styrene were dissolved in 200 g of cyclohexane. The solution was charged into a dried pressure resistant glass bottle and sealed with a crown cap with a hole having packing made of Neoprene (trade name of E.I. du Pont de Nemours and Company). After cooling the pressure resistant glass bottle to -20°C, 5.92 ml of n-butyllithium (1.83 mol/l cyclohexane solution) and 1.96 g of N,N,N',N'-tetramethylethylenediamine were added in this order. The mixture was reacted for one hour while maintaining the temperature at -20°C. Then, 2.0 g of methanol was added to terminate the reaction. The color of the reaction solution was confirmed to turn from red to colorless. After washing with 200 g of 3 wt% oxalic acid-water, 200 g of propylene glycol monomethyl ether and 1.5 g of p-toluenesulfonic acid were added. The mixture was stirred for three hours at room temperature (23-25°C) to be hydrolyzed. The resulting copolymer solution was added dropwise to a large quantity of water to coagulate the copolymer. The produced white powder was filtered and dried overnight at 50°C under reduced pressure.

The copolymer was found to have Mw and Mw/Mn of 8,000 and 1.1 respectively. The result of ¹³C-NMR analysis confirmed that the copolymerization molar ratio of p-hydroxystyrene, styrene, and p-t-butoxystyrene of the copolymer was 72:5:23. This copolymer is referred to as "acid-labile group-containing resin (α-3)".

### Comparative Synthesis Example 4

A solvent refluxed for six hours in the presence of sodium metal and after that distilled under nitrogen atmosphere was used. Monomers were used after bubbling dry nitrogen for one hour, followed by distillation. 37.6 g of p-(1-ethoxy)ethoxystyrene, 11.0 g of p-t-butoxystyrene, and 4.0 g of styrene were dissolved in 200 g of cyclohexane. The solution was charged into a dried pressure resistant glass bottle and sealed with a crown cap with a hole having packing made of Neoprene (trade name of E.I. du Pont de Nemours and Company). After cooling the pressure resistant glass bottle to -20°C, 9.47 ml of n-butyllithium (1.83 mol/l cyclohexane solution) and 3.14 g of N,N,N',N'-tetramethylethylenediamine were added in this order. The mixture was reacted for one hour while maintaining the temperature at -20°C. Then, 3.2 g of methanol was added to terminate the reaction. The color of the reaction solution was confirmed to turn from red to colorless. After washing with 200 g of 3 wt% oxalic acid-water, 200 g of propylene glycol monomethyl ether and 1.5 g of p-toluenesulfonic acid were added. The mixture was stirred for three hours at room temperature (23-25°C) to be partially hydrolyzed p-(1-ethoxy) ethoxystyrene. The resulting copolymer solution was added dropwise to a large quantity of water to coagulate the copolymer. The produced white powder was filtered and dried overnight at 50°C under reduced pressure.

The copolymer was found to have Mw and Mw/Mn of 5,000 and 1.1 respectively. The result of ¹³C-NMR analysis confirmed that the copolymerization molar ratio of p-hydroxystyrene, styrene, and p-t-butoxystyrene of the copolymer was 72:5:23. This copolymer is referred to as "acid-labile group-containing resin (α -4)".

### Examples 1 to 13 and Comparative Example 1 to 4

The composition solutions were prepared by mixing the components in proportions shown in Table 1 and filtered the solution using a membrane filter with a pore diameter of 200nm. In the Table 1, "part" refers to "part by weight". Then, the composition solutions were applied to a silicon wafer with a 60 nm thickness ("DUV42," manufactured by Brewer Science Corp.) by spin coating. The silicon wafer was prepared by spin coating and baking with temperature at 205 °C for 60 seconds. After performing PB under the conditions shown in Table 2 to form a resist coating with a thickness of 270 nm.

Then, the coating was exposed using an Stepper S203B (manufactured by Nikon Corp., lens numerical aperture: 0.68, σ 0.75, 2/3 orbicular zone lightning) under the conditions shown in Table 2, and performed PEB under the conditions shown in Table 2. After performing PEB, the resist film was developed at 23°C for one minute in a 2.38 wt% tetramethylammonium hydroxide aqueous solution by puddling, washed with water, and dried to form a resist pattern. The evaluation results of the resist are shown in Table 2.

Acid generators (B), acid diffusion controllers (C), and solvents (D) shown in Table 1 are described below.

### Acid generator (B):

(B-1): N-(trifluoromethylsulfonyloxy)bicyclo[2.2.1]hept-5-ene-2,3-dicarboxyimide
(B-2): Triphenylsulfonium trifluoromethanesulfonate
(B-3): Diphenyliodonium nonafluorobutanesulfonate
(B-4):N-{(5-methyl-5-carboxymethylbicyclo[2.2.1]hepta-2-yl)sulfonyloxy} sccinimide
(B-5): Bis(p-fluorophenyl)iodonium 10-camphorsulfonate
(B-6): 2,4,6-trimethylphenyl diphenylsulfonium 2,4-difluorobenzenesulfonate
(B-7): Bis(t-butylsulfonyl) diazomethane

### Acid diffusion controller (C):

(C-1): 2-phenylbenzimidazole
(C-2): Trioctylamine

### Solvent (D):

(D-1): Ethyl lactate
(D-2): Ethyl 3-ethoxypropionate
(D-3): Propylene glycol monomethyl ether acetate

Evaluation of resists was carried out as follows.

### (1) Sensitivity

A resist coating was formed on a silicon wafer, exposed to light, and immediately baked (PEB), followed by alkali development, washing with water, and drying. Sensitivity was evaluated based on an optimum exposure dose capable of forming a 1:1 line and space pattern (1L1S) with a line width of 120 nm in each Example and Comparative Example.

### (2) Focal depth allowance (depth of focus: DOF)

A 120 nm line and space pattern (1L1S) was exposed at an optimum dose while changing the depth of focus from -1.0 µm to +1.0 µm at an interval of 100 nm. The focal depth range in which the line width is in the range of 108 nm (-10%) to 132 nm (+10%) was taken as the focal depth allowance.

### (3) Pattern profile (white edge)

Round areas at the top of a 120 nm 1L1S pattern developed with an optimum dose of exposure was observed using a CD-SEM ("S-9220" manufactured by Hitachi High-Technologies Corporation). The width of white parts was measured. The profile is schematically shown in FIG 1. Fig. 1(a) shows the cross-section and Fig. 1(b) is a CD-SEM photograph. Atop area 2a of a pattern 2 formed on the substrate 1 is round and that area with a width d is white. The smaller the width d, the better the pattern profile.

**Table 1**

| | Resin (A) (part) | Acid generator(B) (part) | Acid diffusion controller(C) (part) | Solverst (D) (part) |
|---|---|---|---|---|
| Example | | | | |
| 1 | A-1(100) | B-1(6) | C-1(0.4) | D-1(400) |
| | | | | D-3(400) |
| 2 | A-1(100) | B-1(6) | C-1(0.4) | D-1(400) |
| | | B-2(1) | | D-3(400) |
| 3 | A-1(100) | B-1(6) | C-1(0.4) | D-1(400) |
| | | B-3(1) | | D-3(400) |
| 4 | A-2(100) | B-1(6) | C-1(0.4) | D-1(400) |
| | | | | D-2(400) |
| 5 | A-3(100) | B-1(6) | C-1(0.4) | D-1(400) |
| | | | | D-2(400) |
| 6 | A-4(100) | B-1(6) | C-1(0.4) | D-1(400) |
| | | | | D-2(400) |
| 7 | A-5(100) | B-1(6) | C-1(0.4) | D-1(400) |
| | | | | D-2(400) |
| 8 | A-6(100) | B-1(6) | C-1(0.4) | D-1(400) |
| | | | | D-2(400) |
| 9 | A-1(100) | B-1(6) | C-1(0.4) | D-1(400) |
| | | B-4(1) | | D-3(400) |
| 10 | A-1(100) | B-1(6) | C-1(0.4) | D-1(400) |
| | | B-5(1) | | D-3(400) |
| 11 | A-1(100) | B-1(6) | C-1(0.4) | D-1(400) |
| | | B-6(1) | | D-3(400) |
| 12 | A-1(100) | B-7(7) | C-2(0.3) | D-1(400) |
| | | | | D-3(400) |
| 13 | A-1(100) | B-7(7) | C-2(0.3) | D-1(400) |
| | | B-6(1) | | D-3(400) |

| Comparative Example | | | | |
|---|---|---|---|---|
| 1 | α-1(100) | B-1(6) | C-1(0.4) | D-1(400) |
| | | | | D-2(400) |
| 2 | α-2(100) | B-1(6) | C-1(0.4) | D-1(400) |
| | | | | D-2(400) |
| 3 | α-3(100) | B-1(6) | C-1(0.4) | D-1(400) |
| | | | | D-2(400) |
| 4 | α-4(100) | B-1(6) | C-1(0.4) | D-1(450) |
| | | | | D-2(150) |

**Table 2**

| | PB | | PEB | | DOF (nm) | Sensitivity (J/m²) | Pattern profile (nm) |
|---|---|---|---|---|---|---|---|
| | (°C) | (second) | (°C) | (second) | | | |
| Example | | | | | | | |
| 1 | 120 | 90 | 130 | 90 | 700 | 390 | 6 |
| 2 | 120 | 90 | 130 | 90 | 800 | 410 | 7 |
| 3 | 120 | 90 | 130 | 90 | 800 | 400 | 7 |
| 4 | 120 | 90 | 130 | 90 | 700 | 380 | 6 |
| 5 | 130 | 90 | 130 | 90 | 800 | 380 | 5 |
| 6 | 110 | 90 | 130 | 90 | 700 | 390 | 8 |
| 7 | 120 | 90 | 130 | 90 | 700 | 400 | 8 |
| 8 | 110 | 90 | 130 | 90 | 700 | 400 | 7 |
| 9 | 130 | 90 | 130 | 90 | 700 | 390 | 7 |
| 10 | 130 | 90 | 130 | 90 | 800 | 400 | 6 |
| 11 | 130 | 90 | 130 | 90 | 800 | 400 | 7 |
| 12 | 110 | 90 | 110 | 90 | 700 | 410 | 9 |
| 13 | 110 | 90 | 110 | 90 | 700 | 410 | 9 |

| Comparative Example | | | | | | | |
|---|---|---|---|---|---|---|---|
| 1 | 130 | 90 | 130 | 90 | 500 | 420 | 22 |
| 2 | 130 | 90 | 130 | 90 | 500 | 410 | 18 |
| 3 | 130 | 90 | 130 | 90 | 600 | 400 | 15 |
| 4 | 130 | 90 | 130 | 90 | 600 | 400 | 12 |

The radiation-sensitive resin composition of the present invention exhibits high resolution, excels in focal depth allowance, leaves only minimal development residues, and produced pattern profiles with minimal white edges, while preserving excellent basic characteristics as a resist such as pattern profile, dry etching resistance, and heat resistance. The composition can be suitably used in the field of microfabrication represented by the manufacture of integrated circuit devices which are expected to become more and more miniaturized in the future.

A radiation-sensitive resin composition is provided which exhibits improved resolution, sensitivity, and focal depth allowance (process margin) and can eliminate development residues when forming a resist pattern. The radiation-sensitive resin composition comprises an acid-labile group-containing resin (A) which is insoluble or scarcely soluble in alkali, but becomes alkali soluble by the action of an acid, and a photoacid generator (B), the acid-labile group-containing resin (A) comprises a copolymer prepared by anionic polymerization of monomers including a substituted or unsubstituted styrene and have a terminal shown by the following formula (x). 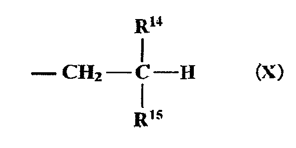 wherein R¹⁴ and R¹⁵ individually represent a hydrogen atom or a linear or branched saturated hydrocarbon group having 1-6 carbon atoms.

## Claims

1. A radiation-sensitive resin composition comprising an acid-labile group-containing resin (A) which is insoluble or scarcely soluble in alkali, but becomes alkali soluble by the action of an acid, and a photoacid generator (B),
wherein the acid-labile group-containing resin (A) comprises a copolymer prepared by anionic polymerization of monomers including a substituted or unsubstituted styrene and have a terminal shown by the following formula (x), 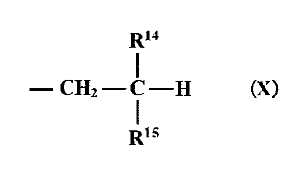 wherein R¹⁴ and R¹⁵ individually represent a hydrogen atom or a linear or branched saturated hydrocarbon group having 1-6 carbon atoms.

2. The radiation-sensitive resin composition according to claim 1, wherein R¹⁴ and R¹⁵ represent the linear or branched saturated hydrocarbon groups having 1-6 carbon atoms.

3. The radiation-sensitive resin composition according to claim 2, wherein the linear or branched saturated hydrocarbon groups having 1-6 carbon atoms are at least one group selected from a methyl group and an ethyl group.

4. The radiation-sensitive resin composition according to claim 1, wherein the formula (x) is shown by the following formula (x-1) or (x-2).

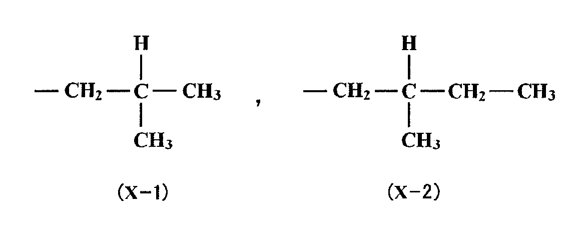

5. The radiation-sensitive resin composition according to claim 1, wherein the terminal of the copolymer shown by the formula (x) is prepared by using a polymerization terminator shown by the following formula (x-3), 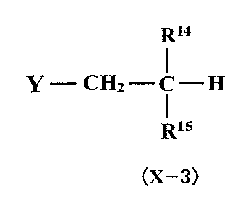 wherein R¹⁴ and R¹⁵ individually represent a hydrogen atom or a linear or branched saturated hydrocarbon group having 1-6 carbon atoms, and Y represents iodine atom or bromine atom.

6. The radiation-sensitive resin composition according to claim 1, wherein the acid-labile group-containing resin (A) is a copolymer containing a recurring unit (A1) having a phenolic hydroxyl group on the side chain and a recurring unit (A2) having an acid-labile group, the recurring unit (A1) being prepared by copolymerizing monomers of the following formula (1) and hydrolyzing the resulting copolymer with an acid, 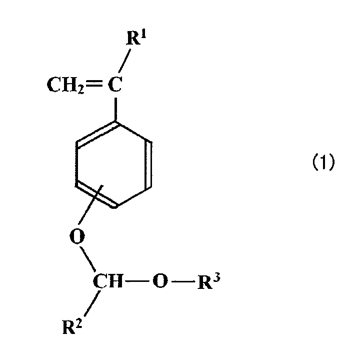 wherein R¹ represents a hydrogen atom or a methyl group, and R² and R³ represent saturated hydrocarbon groups having 1-4 carbon atoms or bond together to form a cyclic ether having 3-7 carbon atoms.

7. The radiation-sensitive resin composition according to claim 6, wherein the recurring unit (A2) having an acid-labile group is prepared by copolymerizing monomers of the following formula (2), 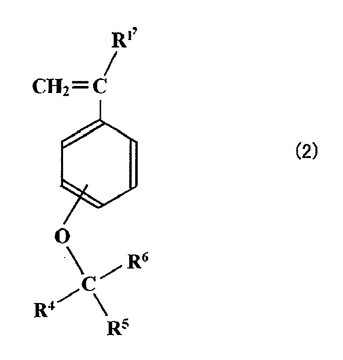 wherein R^{1'} represents a hydrogen atom or a methyl group, and R⁴, R⁵, and R⁶ represent saturated hydrocarbon groups having 1-4 carbon atoms.

8. The radiation-sensitive resin composition according to claim 1, wherein the photoacid generator (B) is at least one compound selected from a sulfonimide compound, an onium salt compound, and a diazomethane compound.

9. The radiation-sensitive resin composition according to claim 8, wherein the photoacid generator (B) comprises the sulfonimide compound.
